# EUROPEAN PATENT APPLICATION

(11) **EP 2 690 937 A1**
(43) Date of publication of application: **29.01.2014**
(21) Application number: 12760452.8
(22) Date of filing: 14.03.2012
(51) Int. Cl.: H05K 3/10, H01B 5/14, H01B 13/00, H01L 21/28, H01L 21/288, H01L 21/3205, H01L 21/768, H01L 23/532, H05K 3/12, H05K 3/22

(54) **METHOD FOR FORMING COPPER WIRING, METHOD FOR MANUFACTURING WIRING SUBSTRATE, AND WIRING SUBSTRATE**

(30) Priority: 24.03.2011 JP 2011065884
(71) Applicant: FUJIFILM Corporation, Tokyo 106-8620 (JP)
(72) Inventor: MATAKI, Hiroshi, Ashigarakami-gun Kanagawa 258-8577 (JP)
(74) Representative: Klunker . Schmitt-Nilson . Hirsch
(86) International application number: PCT/JP2012/056524
(87) International publication number: WO 2012/128139

(57) **Abstract**

Provided are a method of forming copper wiring, a method of manufacturing a wiring board, and a wiring board, which are capable of improving conductivity and suppressing deterioration over a period of time of copper wiring. The method of forming copper wiring includes: a wiring pattern formation step of depositing a suspension (12) onto a substrate (10) to form a wiring pattern of the suspension (12) on the substrate (10), the suspension (12) including dispersed copper particles (14) having an average particle diameter that is not smaller than 100 nm; after the wiring pattern formation step, a drying step of drying the copper particles (14) at a temperature lower than 150°C; after the drying step, a pressure application step of applying pressure to the copper particles (14) in the wiring pattern; after the pressure application step, a heat application step of applying heat to the copper particles (14) in the wiring pattern; and after the heat application step, a reducing treatment step of subjecting the copper particles (14) to a reducing treatment.

## Description

### Technical Field

The present invention relates to a method of forming copper wiring, a method of manufacturing a wiring board, and a wiring board, and more particularly to a method of forming copper wiring, a method of manufacturing a wiring board, and a wiring board, in which copper wiring is formed with use of copper particles having a relatively large particle diameter.

### Background Art

Conventionally, wiring boards which include insulating substrates and wiring patterns made of metal films formed on the surfaces of the insulating substrates, have widely been used for electronic components and semiconductor elements.

For example, Patent Literature 1 describes a method of forming a conductive film on a surface of an insulating film by applying on the surface of the insulating film a paste or liquid with conductive particles dispersed therein and applying at least one of heat and pressure to the applied paste or liquid. Patent Literature 2 describes a method of forming a metal film on a surface of an insulating film by filling metal particles in grooves formed on the surface of the insulating film and applying heat and pressure to the metal particles filled therein.

### Citation List

### Patent Literature

Patent Literature 1: Japanese Patent Application Publication No. 10-056060
Patent Literature 2: Japanese Patent Application Publication No. 11-154676

### Summary of Invention

### Technical Problem

In a case where a wiring pattern is formed by using a suspension with relatively large copper particles (e.g., having particle diameters of not smaller than 100 nm) dispersed therein, there are following problems. In a case where the wiring pattern is formed in the air, it is necessary to perform a reducing treatment after the formation of the wiring pattern to impart conductivity to the wiring pattern because the copper particles oxidize. On the other hand, in a case where the wiring pattern is formed in a non-oxidizing atmosphere, it is necessary to perform a heat treatment at a considerably high temperature to make the copper particles bond to each other to impart conductivity to the formed wiring pattern because copper has a high melting point. Furthermore, in a case where the copper particles are sintered in the air, the copper particles easily bond to each other due to the influence of oxidation; however, since voids between the copper particles are essentially large, the conductivity of the completed copper wiring declines due to deterioration over a period of time.

The present invention has been contrived in view of these circumstances, an object thereof being to provide a method of forming copper wiring, a method of manufacturing a wiring board, and a wiring board, which are capable of improving conductivity by increasing mutual contact areas between copper particles and also capable of suppressing deterioration over a period of time by reducing voids between the copper particles.

### Solution to Problem

In order to attain the aforementioned object, a method of forming copper wiring according to one aspect of the present invention includes: a wiring pattern formation step of depositing a suspension onto a substrate to form a wiring pattern of the suspension on the substrate, the suspension including dispersed copper particles having an average particle diameter that is not smaller than 100 nm; after the wiring pattern formation step, a drying step of drying the copper particles in the wiring pattern at a temperature lower than 150°C; after the drying step, a pressure application step of applying pressure to the copper particles in the wiring pattern; after the pressure application step, a heat application step of applying heat to the copper particles in the wiring pattern; and after the heat application step, a reducing treatment step of subjecting the copper particles in the wiring pattern to a reducing treatment.

According to this aspect, it is possible to suppress oxidation of the copper particles in the drying step, by setting the temperature at which the copper particles are dried after the wiring pattern formation step to be lower than 150°C. Moreover, it is possible to increase mutual contact areas between the copper particles and to thereby improve the conductivity of the copper wiring, by reducing the voids between the copper particles with the pressure application to the copper particles, and thereafter making the copper particles oxidize and bond to each other with the heat application. Furthermore, it is possible to reduce voids present between the copper particles at the time of forming the wiring pattern with the copper particles having the average particle diameter that is not smaller than 100 nm, so that it is possible to improve temporal stability of the copper wiring.

Preferably, the average particle diameter of the copper particles is not smaller than 100 nm and not larger than 200 nm; and a heating temperature in the heat application step is not lower than 150°C.

In the case where the copper particles have the average particle size that is not smaller than 100 nm and not larger than 200 nm, since the voids between the copper particles are relatively small, it is possible to promote oxidation of the copper particles and to obtain sufficient contact areas so that the conductivity of the copper wiring can be secured if the heating temperature in the heat application step is not lower than 150°C.

Preferably, a heating temperature in the heat application step is not lower than 200°C.

According to this aspect, it is possible to make the copper particles reliably bond to each other in the heat application step, so that the conductivity of the copper wiring can be improved.

Preferably, the method further includes: before the wiring pattern formation step, a suspension preparation step of preparing the suspension in a non-oxidizing atmosphere.

According to this aspect, it is possible to suppress oxidation of the copper particles contained in the suspension. In the present method, since the copper particles are made to oxidize and bond to each other by heating in the heat application step, if the copper particles have already oxidized before the heat application step, it is difficult to make the copper particles bond to each other. Therefore, in order to suppress oxidation of the copper particles, it is preferable to prepare the suspension in the non-oxidizing atmosphere.

Preferably, the wiring pattern formation step includes a suspension ejection step of ejecting droplets of the suspension by means of an inkjet method to deposit the droplets onto the substrate.

According to this aspect, it is possible to selectively deposit the suspension only to a portion on the substrate which is necessary for the formation of the wiring pattern, and it is possible to thereby suppress a use amount of the suspension and to thus lower a manufacturing cost of the copper wiring.

Moreover, in order to attain the aforementioned object, a method of manufacturing a wiring board according to one aspect of the present invention includes the above-described method of forming copper wiring.

According to this aspect, the method of manufacturing the wiring board is adequate since it is possible to form the copper wiring with improved conductivity and temporal stability.

Furthermore, in order to attain the aforementioned object, a wiring board according to one aspect of the present invention includes the copper wiring formed by the above-described method of forming copper wiring.

According to this aspect, the wiring board can include the copper wiring with improved conductivity and temporal stability.

### Advantageous Effects of Invention

According to the present invention, voids between copper particles are reduced by applying pressure, and then the copper particles are made to oxidize and bond to each other by applying heat; therefore, it is possible to increase mutual contact areas between the copper particles and to thereby improve conductivity and suppress deterioration over a period of time of copper wiring.

### Brief Description of Drawings

[Fig. 1A] A view for explaining a method of forming copper wiring according to an embodiment of the present invention.
[Fig. 1B] A view for explaining the method of forming copper wiring according to the embodiment of the present invention.
[Fig. 1C] A view for explaining the method of forming copper wiring according to the embodiment of the present invention.
[Fig. 1D] A view for explaining the method of forming copper wiring according to the embodiment of the present invention.
[Fig. IE] A view for explaining the method of forming copper wiring according to the embodiment of the present invention.
[Fig. 2] A table showing measurement results of resistance in copper wirings in Examples of the present invention.
[Fig. 3] A table showing measurement results of resistance in copper wirings in Comparative Examples.
[Fig. 4] A table showing measurement results of resistance in copper wirings in Reference Examples.
[Fig. 5A] A view for explaining a method of forming copper wiring according to the Reference Example.
[Fig. 5B] A view for explaining the method of forming copper wiring according to the Reference Example.
[Fig. 5C] A view for explaining the method of forming copper wiring according to the Reference Example.
[Fig. 5D] A view for explaining the method of forming copper wiring according to the Reference Example.

### Description of Embodiments

Hereinafter, preferred embodiments of the present invention are described with reference to the accompanying drawings.

### {Wiring Pattern Formation Step}

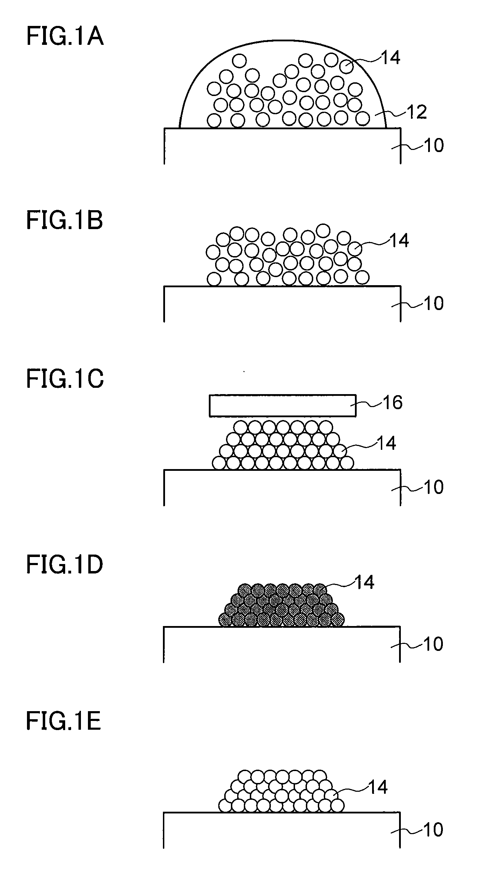

In a method of forming copper wiring according to an embodiment of the present invention, firstly, a suspension 12 in which a plurality of copper particles 14 (copper powder) are dispersed is deposited onto a substrate 10 to form a wiring pattern of the suspension 12 on the substrate 10 (see Fig. 1A). A width of the wiring pattern is preferably not smaller than 50 µm and not larger than 100 µm, without particular limitations.

### <Substrate>

As the substrate 10, substrates of various materials can be used without particular limitations.

### <Suspension>

The suspension 12 includes a suspending medium (continuous phase) and the plurality of copper particles 14 (the copper powder) dispersed within the suspending medium. The suspension 12 can include a dispersing agent that is capable of holding the copper particles 14 in the dispersed state in the suspending medium. The suspension 12 can further include any additive agent that is evaporated or broken at a temperature not higher than a heating temperature in a heat application step, which is described later. In Fig. 1A, only the copper particles 14 are particularly depicted among the contents of the suspension 12.

It is preferable that the copper powder is constituted of the copper particles 14 having a number-average particle diameter measured by scanning electron microscopy (SEM) (hereinafter referred to simply as the "particle diameter") that is not smaller than 100 nm. In the case where the copper particles have the particle diameter that is not smaller than 100 nm, the copper particles do not completely oxidize easily in the air at the normal temperature. On the other hand, in a case where the copper particles have the particle diameter that is smaller than 100 nm, the copper particles completely oxidize easily in the air at the normal temperature.

As the suspending medium, it is possible to use any of various liquids (e.g., cyclohexanone, or the like) without particular limitations, provided that the copper particles 14 can be dispersed therein.

As the dispersing agent, it is possible to use any of various materials without particular limitations, provided that the material is capable of holding the copper particles 14 in the dispersed state in the suspending medium. The dispersing agent is made of the material preferably providing the copper particles 14 with sufficient dispersion stability, and preferably not involving in the conductivity of completed copper wiring.

It is preferable that the suspension 12 is prepared in a non-oxidizing atmosphere. Although the copper particles 14 do not easily oxidize in the air at the normal temperature because the copper powder constituted of the copper particles 14 having the particle diameter that is not smaller than 100 nm is used in the present embodiment, the preparation of the suspension 12 in the non-oxidizing atmosphere is useful for preventing the copper powder from oxidizing.

### <Method of Depositing Suspension>

As the method of depositing the suspension 12 onto the substrate 10, it is possible to use any of various coating methods such as a spin coating method and a dip coating method, or any of various printing methods such as an inkjet printing method and a screen printing method, without particular limitations. In a case where the inkjet printing method is used among these methods, a desired wiring pattern can directly be drawn on the substrate 10 with the suspension 12. Moreover, in the case where the inkjet printing method is used, it is possible to selectively deposit the suspension 12 along a wiring pattern, and it is possible to thereby suppress a use amount of the suspension 12 and to thus lower a manufacturing cost of copper wiring.

### {Drying Step}

Next, the suspending medium is removed from the suspension 12 that has been deposited on the substrate 10 in the pattern formation step, so that the copper powder is dried (see Fig. 1B).

It is preferable that the temperature at which the copper powder is dried in the drying step is lower than 150°C, according to the inventor's knowledge that the copper particles having the particle diameter that is not smaller than 100 nm and not larger than 200 nm oxidize and bond to each other in the air at 150°C. It is more preferable that the temperature at which the copper powder is dried in the drying step is not higher than 100°C, according to the inventor's knowledge that the copper particles having the particle diameter that is not smaller than 100 nm and not larger than 200 nm do not oxidize and bond to each other in the air at 100°C. It is further preferable that the copper powder is not heated in the drying step. By limiting the temperature in the drying step as described above, it is possible to prevent the copper powder from oxidizing.

In the drying step, it is possible to accelerate the drying of the copper powder by blowing air and/or lowering the atmospheric pressure.

### {Pressure Application Step}

Next, the copper powder that has been dried in the drying step is applied with pressure by a pressing device 16, so that the copper powder is compressed and compacted (see Fig. 1C).

In the present embodiment, since the copper powder constituted of the copper particles 14 having the particle diameter that is not smaller than 100 nm is used, there are large voids between the copper particles 14 forming the wiring pattern before the pressure application step. In the pressure application step, it is possible to reduce the voids and increase the mutual contact areas between the copper particles 14. Thus, in the completed copper wiring, it is possible to improve the conductivity, and it is also possible to prevent the conductivity from declining over a period of time.

Examples of the pressure application method in the pressure application step include a calendering process. It is preferable that the pressure applied to the copper powder in the pressure application step is not lower than 100 MPa and not higher than 300 MPa.

### {Heat Application Step}

Next, heat is applied in the air to the copper powder that has been compressed in the pressure application step, so as to make the copper particles 14 bond to each other concurrently with oxidizing (see Fig. 1D).

It is preferable to determine the heating temperature in the heat application step according to the particle diameter of the copper particles constituting the copper powder. In order to impart conductivity to the wiring pattern, it is preferable to heat, in the heat application step, the copper powder at a higher temperature as the particle diameter of the copper particles constituting the copper powder becomes larger. For example, in a case where the copper particles constituting the copper powder have the particle diameter that is not smaller than 100 nm and not larger than 200 nm, conductivity can be imparted to the wiring pattern if the heating temperature in the heat application step is not lower than 150°C. For example, in a case where the copper particles constituting the copper powder have the particle diameter that is larger than 200 nm, conductivity can be imparted to the wiring pattern if the heating temperature in the heat application step is not lower than 200°C.

In the present embodiment, it is important to perform the heat application step after the pressure application step. After reducing the voids between the copper particles 14 forming the wiring pattern with the pressure application, it is possible to further increase mutual contact areas between the copper particles 14 by making the copper particles 14 oxidize and bond to each other with the heat application. If the order of performing the pressure application step and the heat application step is reversed (i.e., the pressure application step is performed after the heat application step), the pressure is applied in the pressure application step to the copper powder in the state where the copper particles have already bonded to each other by heat in the heat application step, and this lowers the effectiveness of the pressure application and makes it difficult to compact the copper powder in the pressure application step. If the pressure application and the heat application are simultaneously performed on the copper powder, the copper particles bond to each other in the state where the copper powder is not sufficiently compacted, and it is then impossible to secure sufficient mutual contact areas between the copper particles. It is necessary, therefore, to perform the pressure application step first and to thereafter perform the heat application step.

Furthermore, in order to reliably make the copper particles 14 oxidize and bond to each other in the heat application step, it is preferable to suppress oxidation of the copper particles 14 before the heat application step. Therefore, as described above, the copper powder constituted of the copper particles 14 having the particle diameter that is not smaller than 100 nm is used, and the preparation of the suspension 12 is performed in the non-oxidizing atmosphere.

### {Reducing Treatment Step}

Next, the copper powder having oxidized in the heat application step is reduced so as to impart conductivity to the copper powder forming the wiring pattern (see Fig. 1E). Thereby, it is possible to make the copper particles 14, which have bonded to each other, function as wiring.

As the reducing treatment, it is possible to use any of various treatments without particular limitations. For example, it is possible to reduce the oxidized copper powder by heating at a temperature of not lower than 350°C and not higher than 400°C in an argon atmosphere containing hydrogen of not less than 3 vol% and not more than 10 vol%.

### <Copper Wiring>

According to the present embodiment, although the copper wiring is formed with use of the copper powder constituted of the copper particles having the particle diameter that is not smaller than 100 nm, it is possible to make the copper particles bond to each other in the heat application step in the state where the voids between the copper particles have been reduced and the mutual contact areas between the copper particles in the pressure application step. Thus, it is possible to improve conductivity as well as temporal stability in the completed copper wiring.

### {Examples}

Copper wirings according to Examples of the present invention were formed respectively with use of copper powder constituted of copper particles having the particle size of 200 nm and with use of copper powder constituted of copper particles having the particle size of 300 nm.

First, a suspension having composition of 50 wt% copper powder and 50 wt% cyclohexanone was prepared in a non-oxidizing atmosphere to prevent the copper powder from oxidizing.

The prepared suspension was deposited on a substrate in the air by the inkjet printing method, so that a wiring pattern was formed on the substrate with the suspension. Then, the copper powder forming the wiring pattern was dried in the air. Then, pressure of about 300 MPa was applied to the copper powder with a calendering device. Then, heat was applied to the copper powder in the air at respective temperatures of 100°C, 150°C, 200°C and 300°C, so as to make the copper particles bond to each other. Then, a reducing treatment was performed on the oxidized copper powder, by which the copper wirings were completed.

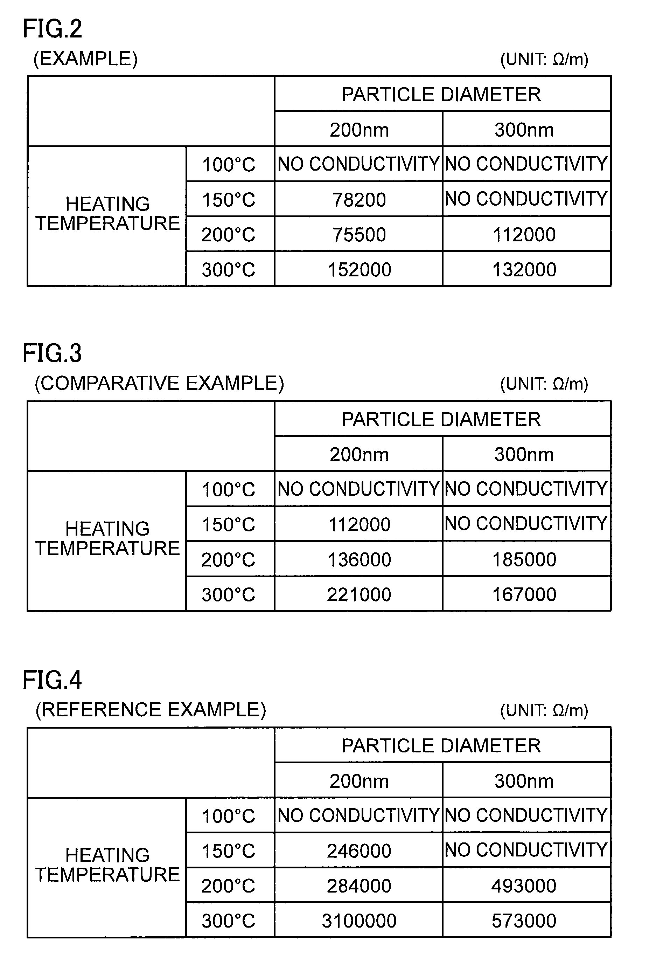

Fig. 2 shows measurement results of resistance in the copper wirings formed as described above.

### {Comparative Examples}

As Comparative Examples, copper wirings were formed by reversing the order of the heat application step and the pressure application step, among the steps described in the aforementioned Examples. Other conditions were similar to those in the Examples.

Fig. 3 shows measurement results of resistance in the copper wirings of the Comparative Examples.

### {Reference Examples}

As Reference Examples, copper wirings were formed without performing the pressure application step among the steps described in the aforementioned Examples. Other conditions were similar to those in the Examples.

Fig. 4 shows measurement results of resistance in the copper wirings of the Reference Examples.

### {Comparison Between Examples}

As shown in Figs. 2 to 4, in comparison with the Comparative Examples where the pressure application step was performed after the heat application step, it was confirmed that the completed copper wirings in the Examples where the heat application step was performed after the pressure application step, had low resistance and high conductivity under all of the particle size and heating temperature conditions. Moreover, in comparison with the Reference Examples where the pressure application step was not performed, it was confirmed that the copper wirings in the Examples had conductivity enhanced by the pressure application.

Furthermore, the conductivity could be imparted to the wiring at a lower heating temperature as the copper particles constituting the copper powder had a smaller particle size. In the Examples, in the case where the copper particles constituting the copper powder had the particle size of 200 nm, the conductivity could be imparted to the wiring by performing the heat application step at the temperature that was not lower than 150°C, whereas in the case where the copper particles constituting the copper powder had the particle size of 300 nm, the conductivity could be imparted to the wiring by performing the heat application step at the temperature that was not lower than 200°C.

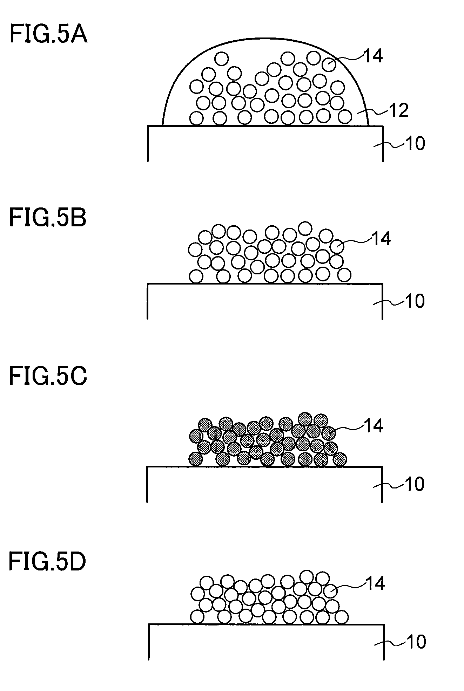

Figs. 5A to 5D show a method of forming copper wiring in the Reference Example. Fig. 5A shows a wiring pattern in the state after the wiring pattern formation step, Fig. 5B shows the copper powder in the state after the drying step, Fig. 5C shows the copper powder in the state after the heat application step, and Fig. 5D shows the copper powder in the state after the reducing treatment step.

In the case where the pressure application step is not performed (the Reference Example), it is considered that the copper wiring has low conductivity because the mutual contact areas between the copper particles are small in the completed copper wiring although the copper particles have bonded to each other, as shown in Fig. 5D. Moreover, since the voids between the copper particles in the completed copper wiring are large, it is considered that the copper wiring has low temporal stability.

Furthermore, the Comparative Example corresponds to a case where pressure is applied in the pressure application step to the copper powder in the state shown in Fig. 5C.

In this case, the copper particles have already oxidized and bonded to each other in the heat application step prior to the pressure application step, and hence, even if pressure is applied to the copper powder in this state in the pressure application step, it is difficult to increase the mutual contact areas between the copper particles and to reduce the voids between the copper particles. Therefore, the copper wiring in the Comparative Example is considered to have a higher resistance value than the resistance value of the copper wiring in the Example.

### Explanation of Reference Numerals

10: substrate; 12: suspension; 14: copper particles; 16: pressing device

## Claims

1. A method of forming copper wiring, the method comprising:
a wiring pattern formation step of depositing a suspension onto a substrate to form a wiring pattern of the suspension on the substrate, the suspension including dispersed copper particles having an average particle diameter that is not smaller than 100 nm;
after the wiring pattern formation step, a drying step of drying the copper particles in the wiring pattern at a temperature lower than 150°C;
after the drying step, a pressure application step of applying pressure to the copper particles in the wiring pattern;
after the pressure application step, a heat application step of applying heat to the copper particles in the wiring pattern; and
after the heat application step, a reducing treatment step of subjecting the copper particles in the wiring pattern to a reducing treatment.

2. The method of forming copper wiring as defined in claim 1, wherein:
the average particle diameter of the copper particles is not smaller than 100 nm and not larger than 200 nm; and
a heating temperature in the heat application step is not lower than 150°C.

3. The method of forming copper wiring as defined in claim 1 or 2, wherein a heating temperature in the heat application step is not lower than 200°C.

4. The method of forming copper wiring as defined in any of claims 1 to 3, further comprising:
before the wiring pattern formation step, a suspension preparation step of preparing the suspension in a non-oxidizing atmosphere.

5. The method of forming copper wiring as defined in any of claims 1 to 4, wherein the wiring pattern formation step includes a suspension ejection step of ejecting droplets of the suspension by means of an inkjet method to deposit the droplets onto the substrate.

6. A method of manufacturing a wiring board, comprising the method of forming copper wiring as defined in any of claims 1 to 5.

7. A wiring board, comprising the copper wiring formed by the method of forming copper wiring as defined in any of claims 1 to 5.
